Europäisches Patentamt

European Patent Office

Office européen des brevets

(11) Publication number: **0 391 081**
**A2**

## (12) EUROPEAN PATENT APPLICATION

(21) Application number: **90104306.7**

(22) Date of filing: **07.03.90**

(51) Int. Cl.⁵: **H01L 21/84, H01L 21/76,**
**H01L 21/82**

(30) Priority: **06.04.89 US 334026**

(43) Date of publication of application:
**10.10.90 Bulletin 90/41**

(84) Designated Contracting States:
**DE FR GB**

(71) Applicant: **International Business Machines**
**Corporation**
**Old Orchard Road**
**Armonk, N.Y. 10504(US)**

(72) Inventor: **Sun, Yuan-Chen**
**3158 Bonit Court**
**Yorktown Heights, N.Y. 10598(US)**

(74) Representative: **Gaugel, Heinz, Dipl.-Ing. et al**
**IBM Deutschland GmbH Schönaicher**
**Strasse 220**
**D-7030 Böblingen(DE)**

(54) **Fabrication and structure of semiconductor-on-insulator islands.**

(57) Fabrication and structure of semiconductor-on-insulator islands, wherein islands of insulating material (4) are formed within a single crystalline semiconductor substrate (2), and islands of semiconductor material (10) of single crystal structure are disposed thereon. The method minimizes semiconductor growth adjacent to insulating material. High qual-ity single crystalline semiconductor on insulator regions are formed that are isolated from one another. The method can be integrated into bipolar, CMOS, or BiCMOS VLSI processes to provide absolute device/circuit isolation without latchup problem and reduce intrinsic and parasitic capacitance.

FIG. 4

EP 0 391 081 A2

## FABRICATION AND STRUCTURE OF SEMICONDUCTOR-ON-INSULATOR ISLANDS

### Technical Field

The invention relates to the fabrication and structure of semiconductor devices, and more particularly, to the fabrication and structure of semiconductor-on-insulator (SOI) islands for advanced CMOS and/or bipolar VLSI circuits.

### Prior Art

Those skilled in the art have long recognized the desirability of semiconductor-on-insulator structures for fabricating semiconductor devices. The resulting circuit and device isolation can eliminate latchup problems and reduce soft errors from alpha particles while reducing intrinsic and parasitic capacitance.

Japanese patent 60-144949 to Watanabe discloses a method of forming semiconductor-on-insulator structures. An insulator layer is formed on a semiconductor substrate, and insulator islands are formed by etching portions of the insulator layer to the substrate level. An epitaxial layer is then grown from the exposed portions of the substrate, eventually overgrowing the insulator islands completely, thereby forming a continuous layer of epitaxy. The epitaxial layer not residing over the insulator islands is then selectively oxidized. In the resulting structure, the remaining portion of the epitaxial layer resides completely on the insulator islands and is surrounded on four sides by the oxidized portions of the epitaxial layer.

Similarly, US-A-4 507 158 to Kamins, et al. discloses a method of creating semiconductor-on-insulator structures, in which the steps used to create the epitaxial layer are essentially the same as the Watanabe patent. Instead of selective oxidation of the epitaxial layer not residing over the insulator islands, trenches are etched down to the insulator island around portions of the epitaxial layer residing thereon. The trenches are then filled with an insulating material, thereby isolating the epitaxial layer inside the filled trench from the remaining epitaxial layer.

The prior art methods of fabrication such as those described suffer from the disadvantage that the epitaxial layer is grown from the substrate surface, vertically along the sides of the insulator islands and then over the islands. It is desirable to minimize the amount of growth of semiconductor epitaxy adjacent the insulating material, since growth from the insulating material can destroy the single crystalline structure of the epitaxial layer.

### Summary of the Invention

The present invention minimizes the epitaxial growth adjacent to insulating material by forming the insulator islands in the semiconductor substrate thereby requiring epitaxy only to be grown over the insulator islands. In the present method, the destruction of the single crystal structure is therefore minimized.

The present invention also achieves more complete physical isolation of the semiconductor-on-insulator structures by tailoring the dimensions of the insulator regions for the type of insulating material.

One aspect of the present invention is a method of fabricating a semiconductor-on-insulator structure in which insulator islands are formed in a single crystalline semiconductor substrate, such that one surface of the islands form a plane surface with the surrounding surface of the semiconductor substrate. A semiconductor layer is formed on the plane surface of the substrate having a continuous single crystalline structure. The region of the semiconductor layer which is not directly over the insulator islands is removed and the remaining regions of the semiconductor layer form semiconductor islands residing completely on the insulator islands which are physically isolated from the underlying semiconductor substrate.

In one specific method of the present invention, the insulator islands are formed in the semiconductor substrate by selective oxidation, while in another they are formed by deposition in etched regions of the substrate. Both specific methods minimize growth of the semiconductor epitaxy adjacent to the insulating material.

In an alternative method of fabricating a semiconductor-on-insulator structure, regions of the surface of a semiconductor substrate are etched wherein semiconductor-on-insulator structures are to reside. A layer of insulating material is formed on the surface of semiconductor substrate, including the exposed surfaces of the etched regions, and then removed to the level of the semiconductor substrate surface, whereby the insulating material layer remains only on the etched regions. Alternatively, a layer of insulation material is selectively grown on the exposed surface of the etched regions by well known techniques. Semiconductor material is then grown on the semiconductor substrate surface, and the etched regions with the layer of insulating material are overgrown with semiconductor material. When the level of semiconductor material grown in the etched regions exceeds the level of the semiconductor substrate surface at all points, the growing is terminated. Growing semiconductor material in this manner results in the formation of a single crystalline semiconductor structure between the semiconductor substrate and the semiconductor layer resulting from growing semiconductor material from the semiconductor substrate surface over the etched regions. The grown semiconductor material layer is removed to at least the level of the semiconductor substrate surface, and the surface comprising the semiconductor substrate with regions of semiconductor material residing on a layer of insulating material is planarized. Consequently, the remainder of the layer of grown semiconductor material resides completely in the etched regions, completely separated physically from the semiconductor substrate by the layer of insulating material. Since the insulator layer is deposited on the semiconductor substrate, the amount of growth of semiconductor epitaxy adjacent to insulating material is minimized.

The present invention also encompasses the structures created by the above methods, which have insulator islands within the semiconductor substrate rather than residing on the surface of the substrate, as is taught by the prior art devices.

In one embodiment of the structure of the present invention, corresponding to the first method of fabrication above, the semiconductor-on-insulator structure includes a semiconductor substrate within which at least one island of insulating material resides, such that one surface of the insulator island(s) form a plane surface with the surface of the semiconductor substrate and at least one single crystal semiconductor material island completely disposed on the one surface of the insulating material island(s), isolated from the semiconductor substrate.

In another embodiment of the structure of the present invention, corresponding to the second method of fabrication above, the semiconductor-on-insulator structure includes at least one removed region in the surface of a semiconductor substrate, and at least one single crystal semiconductor island located within the at least one removed region, isolated from the semiconductor substrate by an insulator layer.

As a result of the minimal growth of single crystal semiconductor material adjacent to insulating material the methods and structures disclosed by the present invention are more efficient, since the semiconductor-on-insulator stacks will have a unitary single crystalline structure, thereby enhancing device performance. In addition, the methods of the present invention use fabrication techniques well known to the art, making the methods simple and economical to implement.

Ways of carrying out the invention are described in detail below with reference to drawings which illustrate only specific embodiments, in which:

Figs. 1-4a illustrate the method sequence of fabrication of the semiconductor-on-insulator structures of the present invention.

Fig. 5 is a top view of the semiconductor-on-insulator structure of Fig. 4.

Figs. 6-9a illustrate an alternative method sequence of the fabrication of the semiconductor-on-insulator structures of the present invention.

Detailed description of the Preferred Embodiment of the Invention

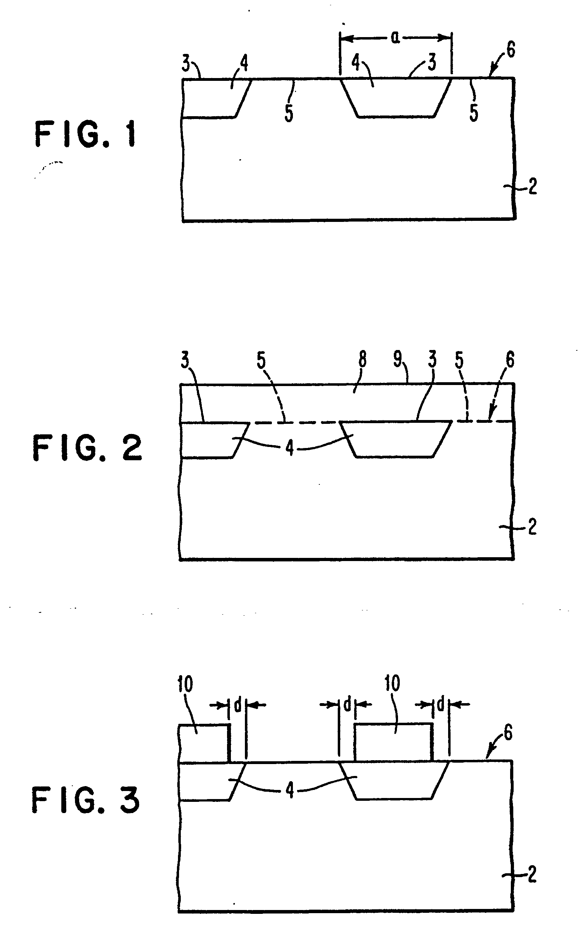

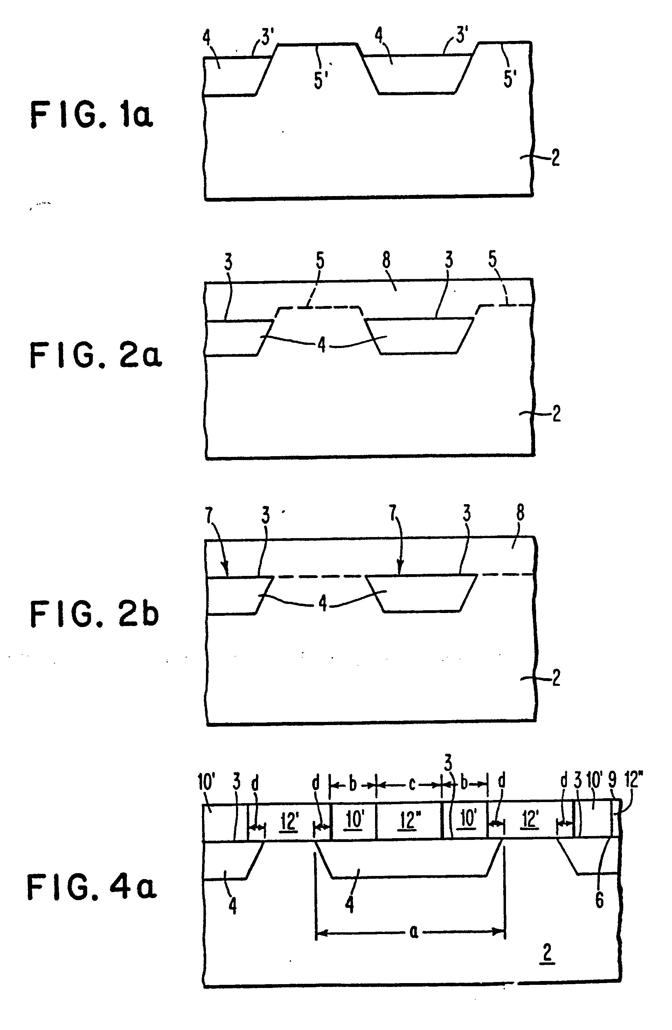

Referring to Figure 1, a portion of a cross-section of a semiconductor substrate 2 is shown with islands of insulator material 4 residing therein. The surface 3 of the insulator islands 4 and the surface 5 of the semiconductor substrate 2 form planar surface 6. The semiconductor substrate 2 and insulator islands 4 are three dimensional, and each insulator island 4 is completely surrounded by semiconductor substrate 2.

Insulator islands 4 may be formed in semiconductor substrate 2 by several methods. One method is to mask a plane surface of a unitary semiconductor substrate 2 using a resist or a nitride/oxide stack (pad) patterned by a resist, etch regions of the substrate in which insulator islands 4 are to reside, deposit insulating material using chemical vapor deposition techniques until the insulating material exceeds the semiconductor substrate 2 surface, remove the mask and excess insulating material and planarize the surface 6 of the semiconductor substrate 2. The masking and etching techniques are known to the art. Removal of the mask and excess insulating material, as well as the planarization of surface 6, can be accomplished by chemical-mechanical polishing, or resist planarizing and reactive ion etch back.

Alternatively, insulator islands 4 may be formed in the semiconductor substrate 2 by masking the regions of a surface of semiconductor substrate 2 adjacent to the regions where insulator islands 4 are to be formed and using a thermal oxidation process to form insulator islands 4 in the non-masked regions. The mask is then removed, and plane surface 6 of semiconductor substrate 2 with insulator islands 4 is formed. The mask may be a resist or a nitride/oxide stack (pad) patterned by a resist and the thermal oxidation procedures are known to the art. The resist or nitride/oxide stack may be selectively removed and, if necessary, the surface 6 may be planarized by chemical-mechanical polishing, or resist planarizing and reactive ion etch back.

The two methods described above for forming insulator islands 4 offer distinct advantages since the insulator islands 4 are formed within the semiconductor substrate 2. The prior art methods of fabricating semiconductor on insulator structures use the technique of growing semiconductor around deposits of insulating material to form the insulator islands. However, it is well known in the art that the growth of single crystalline semiconductor structure relies on the epitaxial deposition of semiconductor material on the underlying semiconductor substrate, and that the structure is destroyed if it is deposited directly on insulating material. By using techniques where the epitaxy must be grown in the regions between the insulator islands, the semiconductor must be grown adjacent to the sidewalls of insulator islands, resulting in a greater probability of destroying the single crystalline structure of the semiconductor substrate. The above methods avoid that potential problem.

Referring to Figure 1a, a modification of the structure of Figure 1 is shown. In Figure 1a, the insulator islands 4 have planar surfaces 3 which lie below the surface 5 of semiconductor substrate 2. Whatever method is used to arrive at the structure in Figure 1, the surface 3 of insulator islands 4 may be partially etched to achieve the structure shown in Figure 1a. The structure of Figure 1a facilitates the next fabrication step and is described below. The thickness of the insulator island should be at least approximately .2$\mu$m for adequate insulation of the SOI islands.

Referring to Figure 2, a semiconductor layer 8 is epitaxially grown from the semiconductor substrate surface regions 5 and laterally overgrows the surface regions 3 of insulator island regions 4. In this manner, the semiconductor layer 8 is grown entirely with a single crystalline structure resulting in a unitary single crystalline structure of semiconductor layer 8 and semiconductor substrate 2.

Thus, insulator islands 4 are completely surrounded by single crystal semiconductor material. The surface 9 of the semiconductor layer 8 is planarized, by any suitable method, such as by chemical-mechanical polishing, or resist planarizing and reactive ion etch back. Alternatively, the epitaxial growth of layer 8 may be interrupted or successive oxidation and etch back may be used to achieve a smoother planar surface and the derived epilayer thickness over the insulator islands 4.

In Figure 2 it is assumed that the structure of Figure 1 is used in the lateral overgrowth step. That is, epitaxial growth is initiated at the substrate surface 5, shown by dashed lines in Figure 2, which is coplanar with the insulator island surfaces 3. Referring to Figure 2a, the structure of Figure 1a is used in the lateral overgrowth step. That is, epitaxial growth is initiated at the substrate surface 5, shown by dashed lines in Figure 2a, which lies above insulator island surfaces 3. By using the non-coplanar structure, single crystalline growth from the substrate surface 5 is facilitated.

Referring to Figure 2b, the resulting structure of the lateral overgrowth step is shown. Since the epitaxy layer 8 and the substrate 2 have single crystalline structure, the dashed line representing the original substrate surface has been removed. The resulting structure after the growth step is, of course, equivalent whether the structure of Figure 1 or 1a is used. Seam 7 may be present as shown in Fig. 2b after the growth step at the point where epitaxy grown from both sides of an insulator island 4 converges. However, if epitaxy is grown from one side of the insulator island 4 to the other, seam 7 will not be present. In the immediately following discussion the seam 7 will be assumed to not exist or, if it does, its effects will be ignored. A modification of the final structure will be presented below which eliminates the seam if it is in fact present.

Referring to Figure 3, regions of the semiconductor layer 8 of Figure 2 are then removed by conventional masking and etching techniques so that the remaining regions form semiconductor islands 10 residing completely on insulator islands 4. The semiconductor islands 10 may be formed by applying a mask to the regions of surface 9 of layer 8 of Figure 2 which are to form the semiconductor islands 10 and reactive ion etching the exposed regions of semiconductor layer 8 to the planar surface 6. The mask is then removed from the surface of semiconductor islands 10 using standard techniques, thereby forming semiconductor islands 10 residing completely on insulator islands 4.

Figure 3 shows that semiconductor islands 10 lie on insulator islands 4 within the perimeter 11 of the insulator islands 4 by a margin d. The semiconductor islands 10 are therefore completely physically isolated from semiconductor substrate 2. The minimum width of d to achieve physical isolation of semiconductor devices fabricated using semiconductor islands 10 is known in the art, and is generally on the order of 0.1 - 0.2um. For a silicon substrate 2 and silicon islands 10 on a silicon dioxide insulator 4, d is at least 0.1um to achieve acceptable electrical isolation of the silicon island 10 from the substrate 2. The present invention also encompasses the case for d = 0 and where semiconductor island 10 extends over insulator island 4 onto semiconductor substrate 6. Such a case is not a preferred embodiment since the degree of electrical isolation is reduced.

In both cases the original island size on the mask can be deliberately made smaller by approximately one alignment tolerance. Subsequent resist exposure and/or etch biasing as well as oxidation can make the island grow to allow for subsequent alignment tolerances.

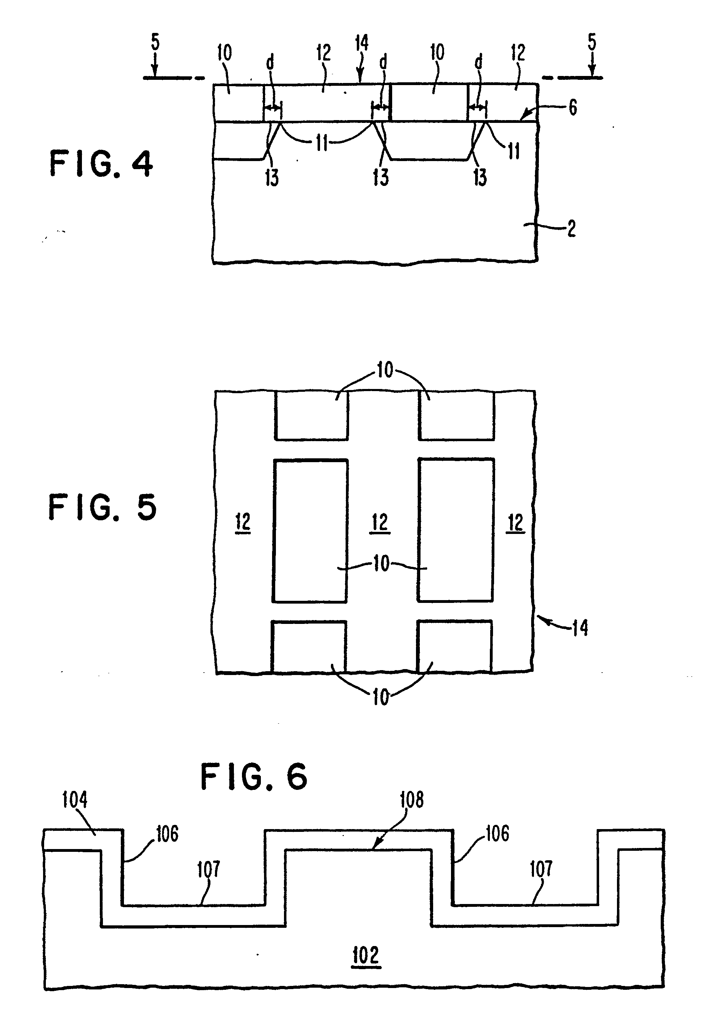

An optional fabrication step includes forming an insulator layer 12 between semiconductor islands 10 on planar surface 6, as shown in Figure 4.

The insulator layer 12 can be the same material as insulator island 4, or it may be different. The layer 12 may be formed by a chemical vapor deposition process in which the insulator material is deposited until the regions adjacent to the semiconductor islands 10 are completely filled, and then the surface is planarized using standard techniques to form planar surface 14. The semiconductor islands 10 are surrounded on five sides by an insulating material, i.e., on the bottom by insulator islands 4, and on the sides by insulator layer 12. The overlap 13 of insulator layer 12 and insulator islands 4 at planar surface 6 maintains semiconductor islands 10 physically isolated from semiconductor substrate 2.

Referring to Figure 5, a view of Figure 4 along the line 5-5 is shown. The complete view in Figure 5 is of planar surface 14 consisting of insulator layer 12 surrounding semiconductor islands 10. The isolated semiconductor islands 10 may be used to fabricate semiconductor devices such as bipolar and/or field effect transistors. Wiring contacts may be made borderless. This method can be integrated into bipolar, CMOS, or BiCMOS VLSI processes to provide absolute device/circuit isolation without latchup problem and reduce intrinsic and parasitic capacitance.

Referring to Figure 4a, a SOI structure similar to Figure 4 is shown. However, two semiconductor islands 10′ reside on insulator island 4 separated by a region of insulating material 12″. The steps described above which correspond to Figures 3 and 4 may be used to create the structure in Figure 4a. That is, the epitaxial layer of the structure of Figures 2, 2a or 2b may masked and etched such that two semiconductor islands 10′ reside complete on insulator islands 4. This step can occur after or concurrently with the removal of the epitaxial layer not residing over the insulator islands. Similarly, the optional step of "filling in" the regions between semiconductor islands 10′ with insulating material 12′, 12″ may be accomplished by a chemical vapor deposition process followed by planarizing. It is seen from the parameters labelled a, b, c and d in Figure 4a that a ≥ 2d + 2b + c. The width d is the minimum width to isolate semiconductor island 10′ from substrate 2 as described above. The width c must be wide enough to provide isolation between adjacent semiconductor islands.

If the epitaxy layer had a seam 7 as shown in Figure 2b and described above, comparison of Figures 2b and 3 shows the seam would be located within a single semiconductor island residing on an insulator island. However, by fabricating two semiconductor islands on one insulator island, the region removed between the two semiconductor islands, shown in Figure 4a filled with insulating material 12″, may be chosen to eliminate the seam. Naturally, the steps above can be used to fabricate more than two semiconductor islands on a single insulator island.

The semiconductor substrate 2 of Figures 1-4 is typically silicon, and the insulator islands 4 are typically silicon dioxide or silicon nitride. The insulator layer 12 may be silicon dioxide and the semiconductor islands 10 may be silicon. The invention is not limited to these materials, and one skilled in the art can easily apply the methodology to analogous semiconductor and insulator materials, such as germanium and germanium oxide and nitride.

Figures 6-9a show an alternative method of fabrication and structure of the semiconductor-on-insulator structure of the present invention.

Referring to Figure 6, removed regions 106 may be formed by masking and etching. Insulator layer 104 may be formed by chemical vapor deposition techniques, or a thermal oxidation process. Insulator layer 104 completely overlays the surface of semiconductor substrate 102 and removed regions 106. The surface 107 of insulator layer 104 at the bottom of removed region 106 does not exceed the level of the surface 108 of semiconductor substrate 102.

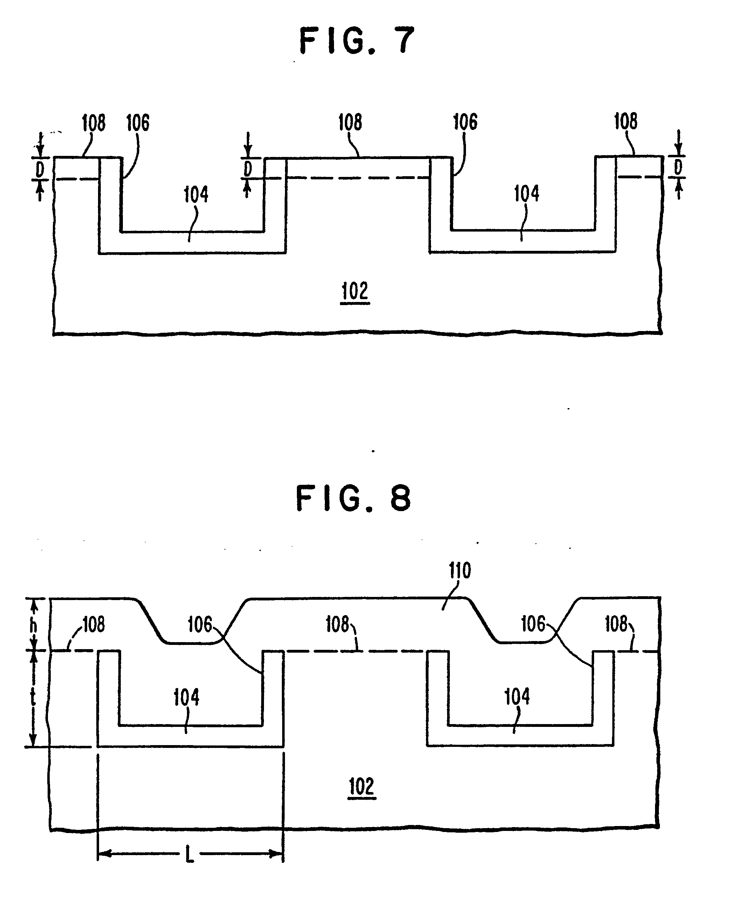

Referring to Figure 7, insulator layer 104 is removed from the surface 108 of semiconductor substrate 102, but not the surfaces of semiconductor substrate 102 forming removed regions 106. The insulator layer 104 atop surface 108 may be removed by chemical-mechanical polishing, or resist planarizing and reactive ion etching back of the insulator layer 104 until surface 108 is exposed. The removal process may remove a margin of the semiconductor substrate 102, shown in Figure 7 as D, without changing the basic structure of Figure 7.

Alternatively, the structure of Figure 7 may be arrived at directly by selective deposition of insulator layer 104 on the exposed surface of removed region 106.

Referring to Figure 8, semiconductor layer 110 is selectively grown from the exposed semiconductor substrate regions, i.e., surface 108, and laterally grown over insulator layer 104 to fill in removed regions 106. By growing from the semiconductor substrate 102 at surface 108, semiconductor layer 110 and semiconductor substrate 102 have a unitary crystalline structure, including that portion of semiconductor layer 110 in removed region 106. The dashed line at surface 108 of semiconductor substrate 102 is intended to represent this.

Semiconductor layer 110 is grown higher than surface 108 at all points in removed region 106. For this, the height shown as h in Figure 8 must be related to the dimension L in Figure 8 such that $h \geq \frac{1}{2} L + t$, where the dimension shown as t in Figure 8 is such that $t \geq \frac{1}{2} L$ and L is the smallest horizontal cross section of the removed region 106.

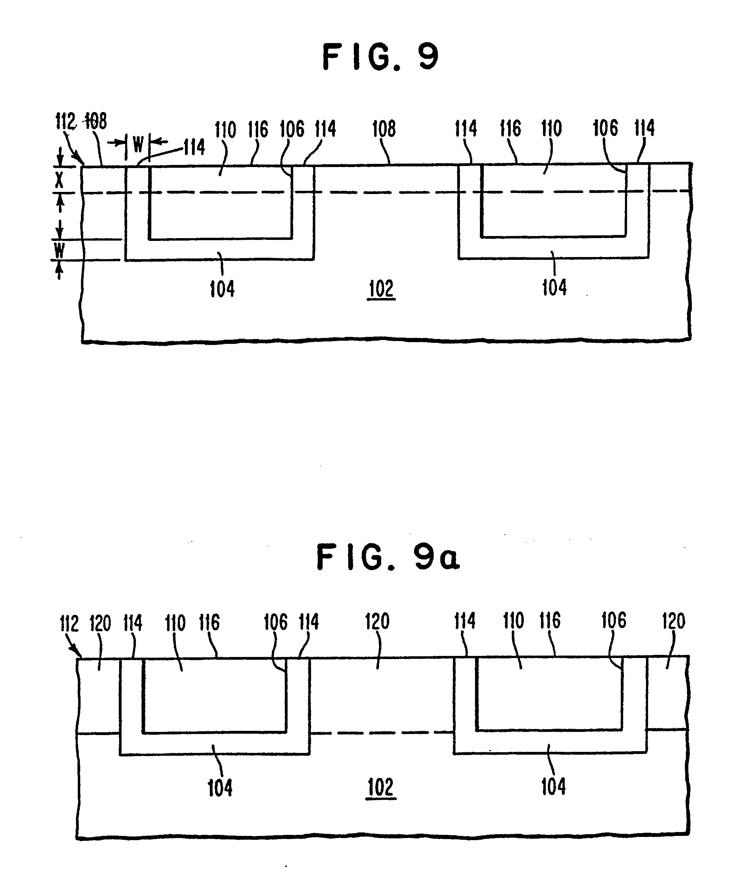

Referring to Figure 9, the semiconductor layer 110 above surface 108 is removed by chemical-mechanical polishing, or resist planarizing and reactive ion etch back to form planar surface 112. The planarizing need not terminate exactly at the original surface 108 of the semiconductor substrate 102, but may remove an additional margin of the surface, shown as X in Figure 9, and still achieve the equivalent semiconductor-on-insulator structures of Figure 9. Remaining semiconductor layer 110 in the removed regions 106 are completely surrounded by insulator layer 104, thereby physically separated from semiconductor substrate 102. Semiconductor layer 110 in removed regions 106 forms the semiconductor-on-insulator structure analogous to that of Figure 4. Planar surface 112 consists of the exposed surface 108 of semiconductor substrate 102, top surfaces 116 of semiconductor islands 110, and the exposed surface 114 of the insulator layer 104 which surrounds the semiconductor islands 110.

An optional fabrication step includes forming an insulator layer 120 between semiconductor islands 110 on planar surface 112, as shown in Figure 9a. Regions of exposed surface 108 in Figure 9 may be etched and then filed with insulating material by selective deposition.

Two or more insulator islands may be formed in a single removed region by removing a strip of the epitaxy layer of the semiconductor island 110 in Figures 9 and 9a to the insulating layer 104 and then filing the removed region with insulating material. This could be used to remove a seam that might result from the overgrowing step.

The method described gives a semiconductor-on-insulator structure functionally equivalent to that achieved using the first method above. Therefore the advantages of fabricating semiconductor devices using the prior method apply equally to this method, and the same particular materials and dimensions may also be used. Of course, the dimension w shown in Figure 9 is the relevant dimension for physical isolation of semiconductor island 110 from semiconductor substrate 102, and is typically on the order of 0.2μm for silicon dioxide on a silicon substrate.

While the invention has been particularly shown and described, it will be understood by those skilled in the art that the foregoing and other changes in form and details may be made therein without departing from the spirit and scope of the invention.

## Claims

1. A semiconductor-on-insulator structure comprising:
a semiconductor substrate (2) having at least one insulating material (4) island disposed therein, the upper surface (3) of said at least one insulating material island (4) forming a planar surface (6) with the surface (5) of said semiconductor substrate (2); and
each of said at least one insulating material island (4) having one or more single crystal semiconductor material island (10) disposed on said upper surface (3), each of said one or more semiconductor material islands (10) being isolated from said semiconductor substrate (2).

2. The structure according to claim 1 wherein the perimeter of said one or more semiconductor material islands (10) is completely inside and does not contact the perimeter of said upper surface (3) of said at least one insulating material island (4).

3. The structure according to claim 1 or 2 wherein said one or more semiconductor material islands (10) reside inside the perimeter of said at least one insulating material island (4) by at least 0.1 μm.

4. The structure according to one or more of the preceding claims 1 to 3 wherein said one or more semiconductor material islands (10) are separated by a distance (c) which provides electrical isolation between the islands (10).

5. The structure according to one or more of the preceding claims 1 to 4 wherein said structure further includes a layer of insulating material (12) disposed on said planar surface (6) of semiconductor substrate (2) and said at least one insulating material island (4), said layer of insulating material (12) surrounding and forming a planar surface with said one or more semiconductor material island (10).

6. A semiconductor-on-insulator structure comprising:
a semiconductor substrate (102) having at least one removed region (106) with one or more single crystal semiconductor islands (110) disposed within said at least one removed region (106), said one or more islands (110) being isolated from said substrate (102) by an insulator layer (104).

7. The structure according to claim 6 wherein said one or more semiconductor islands (110), said insulator layer (104) and said semiconductor (102) substrate have coplanar surfaces.

8. The structure according to claim 6 or 7 wherein said insulator layer (104) is of uniform thickness.

9. A method of fabricating a semiconductor-on-insulator structure, preferably a semiconductor-on-insulator structure according to one or more of the preceding claims 1 to 5, comprising the steps of:
forming at least one insulator island (4) in a semiconductor substrate (2), with at least one exposed surface (3), said semiconductor substrate (2) having a single crystalline structure;
forming a semiconductor layer (8) on said surface (5, 3) of said semiconductor substrate (2) and said at least one insulator island (4), said semiconductor layer (8) having a planar surface (9) and forming a continuous single crystalline structure with said semiconductor substrate (2), and
removing the region of said semiconductor layer (8) which is not directly over said at least one insulator island (4), whereby the remaining regions of said semiconductor layer (8) form at least one semiconductor island (10) disposed on said at least one insulator island (4) isolated from said semiconductor substrate (2).

10. The method according to claim 9 wherein the step of forming at least one insulator island (4) with at least one exposed surface (3) includes forming a coplanar surface (6) between the exposed surface (3) and the surrounding surface (5) of the semiconductor substrate (2).

11. The method according to claim 9 wherein the step of forming at least one insulator island (4) with at least one exposed surface (3') includes forming the exposed surface (3') beneath the surface (5') of the surrounding semiconductor substrate (2) and parallel to it.

12. The method according to one or more of the preceding claims 9 - 11 wherein said at least one insulator island (4) is formed by:
applying a mask having at least one opening to said semiconductor substrate (2) and thermally oxidizing the semiconductor substrate (2) through said at least one opening thereby forming said at least one insulator island (4) surrounded by semiconductor material; and removing said mask and planarizing the exposed surface (3) of said at least one insulator island (4) and said surrounding semiconductor substrate (2) such that the surfaces (3, 5) are coplanar.

13. The method according to one or more of the preceding claims 9 - 11 wherein said at least one insulator island is formed by:
applying a masking layer having at least one opening;
etching regions of the surface (5) of said semiconductor substrate (2) through said at least one opening; depositing insulating material in said etched regions of said semiconductor substrate surface, thereby forming said at least one insulator island (4) surrounded by semiconductor material; and removing said masking layer and planarizing the exposed surface (3) of said at least one insulator island (4) and said surrounding semiconductor substrate surface (5) such that the surfaces are coplanar.

14. The method according to claim 12 or 13 further including the step of removing the exposed surface (3) of said at least one insulator island (4) so that it is parallel to and beneath the surface (5) of the semiconductor substrate (2).

15. The method according to one or more of the preceding claims 9 to 14 wherein said semiconductor layer (8) is formed on said surface (3, 5) of said semiconductor substrate (2) and said at least one insulator island (4) by:
epitaxially growing semiconductor material from said surrounding surface (5) of said semiconductor substrate (2), said epitaxially grown semiconductor material laterally overgrowing said at least one insulator island (4), thereby forming a continuous layer (8) of single crystalline semiconductor material extending from said semiconductor substrate (2), and planarizing said epitaxially grown semiconductor layer (8).

16. The method according to claim 15 wherein the growing of the epitaxial layer (8) exceeds the desired thickness of the layer at all points, and the excess is removed and the layer is planarized by mechanical-chemical polishing or by chemical removal.

17. The method according to one or more of the preceding claims 9 to 16 wherein the regions of said semiconductor layer (8) which are not directly over said at least one insulator island (4) are removed by applying a mask over the regions of the semiconductor layer (8) completely over said at least one insulator island (4), etching the exposed regions of said semiconductor layer (8) to said semiconductor substrate (2), and removing the lithographic mask.

18. The method according to claim 15 wherein the planarizing of the epitaxial layer (8) is achieved by successive oxidizing and etching back the epitaxial layer (8) at least one time.

19. A method of fabricating a semiconductor-on-insulator structure, preferably a semiconductor-on-insulator structure according to one or more of the preceding claims 6 to 8, comprising the steps of:
removing at least one region (106) of the surface of a semiconductor substrate (102) wherein at least one semiconductor-on-insulator structure (110) is to reside,
forming a layer of insulating material (104) on the surface of said at least one removed region (106), the level (107) of said insulating layer (104) in said at least one removed region (106) being below said surface (108) of said semiconductor substrate (102), growing semiconductor material (110) from the surface (108) of said semiconductor substrate (102), said grown semiconductor material (110) forming a single crystalline structure with said semiconductor substrate (102),

laterally overgrowing said at least one removed region (106) with said layer of insulating material (104) with semiconductor material (110) until the level of semiconductor material (110) grown in said at least one removed region (106) exceeds the level of the surface (108) of said semiconductor substrate (102) at all points, whereby a single crystalline semiconductor structure is formed between said semiconductor substrate (102) and said semiconductor layer (110) resulting from growing semiconductor material (110) from said semiconductor substrate surface (108) over said at least one removed region (106), and

removing said grown semiconductor material layer (110) above the surface (108) of said semiconductor substrate (102) whereby the remainder of said layer of grown semiconductor material forms at least one semiconductor island (110) disposed completely on said layer of insulating material (104) in said at least one removed region (106) isolated from said semiconductor substrate (102).

20. The method according to claim 19 wherein said step of forming said layer of insulating material (104) further includes forming said layer of insulating material (104) on said surface (108) of said semiconductor substrate (102) and removing said layer of insulating material (104) above the surface (108) of said semiconductor substrate (102) whereby said insulating material layer (104) remains only on the surfaces defining said at least one removed region (106).

21. The method according to claims 19 or 20 wherein said at least one removed region (106) is formed by applying a mask having at least one opening to said semiconductor substrate (102), etching regions of the surface (108) of said semiconductor substrate (102) through said at least one opening, and removing said mask.

22. The method according to one or more of the preceding claims 19 to 21 wherein said layer of insulating material (104) is formed by depositing insulating material or by thermally oxidizing the surface (108) of said substrate (102).

23. The method according to one or more of the preceding claims 19 to 22 wherein the step of removing said grown semiconductor material layer (110) above the surface (108) of said semiconductor substrate (102) further includes removal of said semiconductor material layer (110), semiconductor substrate (102), and insulating layer (104) which is above a plane parallel to the surface (108) of said semiconductor substrate (102), said plane being located below the surface (108) of said semiconductor substrate (102) and above said insulating layer (107) at the bottom of said removed region (106).

24. The method according to one or more of the preceding claims 9 to 23 wherein the step of removing regions of said semiconductor layer (110) further comprises concurrently or later removing one or more portions of said semiconductor layer (110) residing on said layer of insulating material (104) in said at least one removed region (106) or disposed on said at least one insulator island (4) so that two or more semiconductor islands (10', 110) reside on said layer of insulating material (104) in said at least one removed region (106) or are disposed on said at least one insulator island (4) isolated from said semiconductor substrate (2, 102) and from adjacent semiconductor islands (10', 110).

25. The method according to claim 24 which further includes the step of depositing insulating material (12) in said removed portions of said semiconductor layer (10, 110), whereby said semiconductor islands (10', 110) are surrounded on five sides by insulating material.

26. The method according to claim 24 wherein said removing of one or more portions of said semiconductor layer (10, 110) includes removing one or more seams (7) in said semiconductor layer (10, 110) resulting from the step wherein said semiconductor layer (10, 110) is formed or grown on said semiconductor substrate (2, 102) and said at least one insulator island (4) or said at least one removed region (106).

FIG. 1

FIG. 2

FIG. 3

FIG. 1a

FIG. 2a

FIG. 2b

FIG. 4a

**FIG. 4**

**FIG. 5**

**FIG. 6**

# FIG. 7

# FIG. 8

# FIG. 9

# FIG. 9a